# EUROPEAN PATENT APPLICATION

(11) **EP 1 850 383 A1**
(43) Date of publication of application: **31.10.2007**
(21) Application number: 06008505.7
(22) Date of filing: 25.04.2006
(51) Int. Cl.: H01L 25/075, H01L 33/00

(54) **Three wavelength light emitting diode**

(71) Applicant: ILED Photoelectronics Inc., Wugu Township T'ai pei (TW)
(72) Inventor: Lee, Ko-hsin, Sindian City Taipei County 231 (TW); Sun, Tseng-Bao, Taichung City 401 (TW)
(74) Representative: Hauck Patent- und Rechtsanwälte

(57) **Abstract**

A three wavelength light emitting diode (LED) structure utilizes a blue light LED chip and a green light LED chip as light sources, and a red fluorescent layer is used as a light transition layer. By adjusting the operation current of the blue light LED chip and the green light LED chip and the dosage of the chemical substances in the red fluorescent layer, the present invention can produce a white light LED which is adjustable in color temperature, a neutral color LED whose color is changeable, or can produce a LED whose light color changes with time.

## Description

### BACKGROUND OF THE INVENTION

### Field of the Invention

The present invention relates to LED field, and more particularly to a three wavelength LED structure.

### Description of the Prior Art

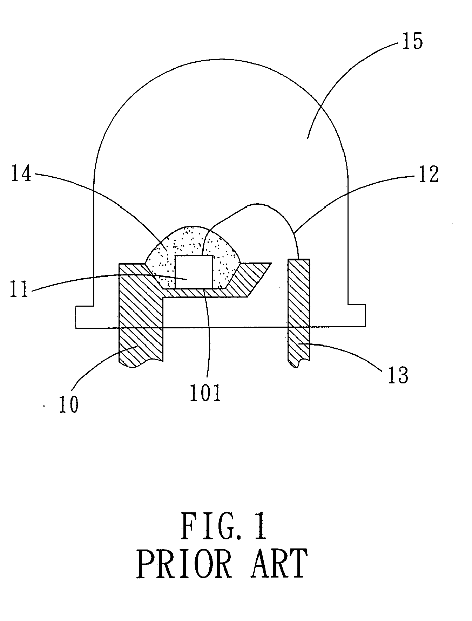

Light emitting diode (LED) is a commonly seen high efficiency light emitting element, as shown in Fig. 1, which is a conventional bulb-shaped single color LED package structure. A single color LED chip 11 is placed in a cup 101 of an electrode supporting frame 10 and is electrically connected to another electrode supporting frame 13 by a wire 12. The cup 101 is filled with a transparent resin 14 for sealing and protecting the single color LED chip 11, and finally, these components are encapsulated by a colloid 15, thus forming a bulb type single color LED.

Since this conventional single color LED uses the chip as a light source, it only can generate a single color light due to the physical characteristic of the LED. If want to generate multiple colored light, it requires the cooperation of multicolor chips. However, according to the color forming principle, the cooperation of three primary color LED chips (red, blue and green) is unable to produce an even white light, therefore, the applicability of the LED chip is limited.

Furthermore, based on the LED chip's physical characteristic, the resin contains chemical substances that can switch wavelength, so that the substances in the resin can convert light color by color mixing or absorbing. Therefore, the LED can be used as a multicolor light source.

The industry today is developing toward miniaturization, and meanwhile, surface mounting technology is introduced in the LED production so as to reduce the LED to the smallest possible size.

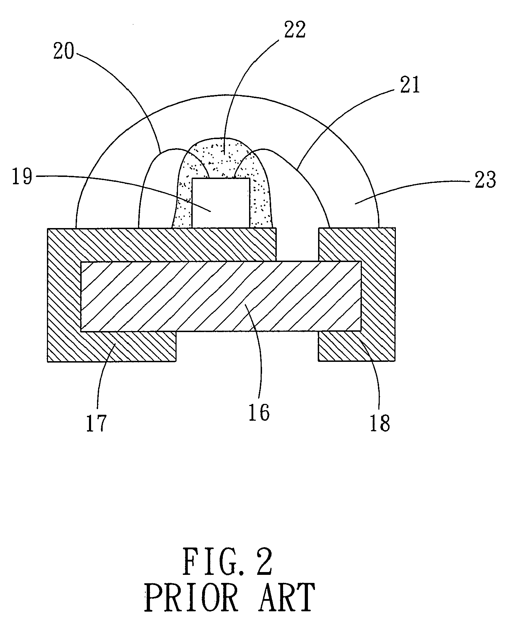

Referring to Fig. 2, which shows a white light LED package structure formed by surface mounting technology. In this structure, conductive layers 17 and 18 are arranged on the periphery of a substrate 16. A blue light LED chip 19 is placed on the conductive layer 17 and is electrically connected to the conductive layers 17 and 18, respectively, by two welding wires 20 and 21. The blue light LED chip 19 is coated with a resin 22 containing yellow fluorescent agents, and then is encapsulated by a colloid 23, thus forming a white light LED package structure.

The white light LED package structure shown in Fig. 2 uses the blue light LED chip as a light source, and the resin having yellow fluorescent agent converts the blue light into white light. Therefore, this white light LED package structure can be used as a white light source, and because its primary color is blue, a part of the blue light will leak through the clearance of the fluorescent layer, creating an effect that the white light looks very clean and clear.

The light generated by the conventional LED is white only in visual effect, but in fact, the white light is a combination of blue light and yellow light, without the red light, and the light color cannot be changed once the final product is finished. In addition, the color temperature of the conventional white light LED is difficult to control, and particularly, it is unable to produce a warm effect at the color temperature of 3500k. Moreover, the color rendering of the produced white light is very poor, it is unable to completely replace the white light source.

The present invention has arisen to mitigate and/or obviate the afore-described disadvantages.

### SUMMARY OF THE INVENTION

The primary objective of the present invention is to provide a three wavelength LED structure that can generate white lights of different color temperatures.

The secondary objective of the present invention is to provide a three wavelength LED structure that can generate neutral color light.

Another objective of the present invention is to provide a three wavelength LED structure whose light color is adjustable within a limited range.

A three wavelength LED structure provided in accordance with the present invention comprise a substrate, a conductive structure on the substrate, at least one blue light LED chip, at least one green light LED chip and a red fluorescent layer. The blue light LED chip and the green light LED chip are placed on the substrate or on the conductive structure and electrically connected to the conductive structure. The blue light LED chip does not contact the green light LED chip. The blue light LED chip and the green light LED chip are encapsulated by the red fluorescent layer and the red fluorescent layer can covert the wavelength emitted by the two LED chips.

According to the abovementioned three wavelength LED structure, the blue light LED chip and the green light LED chip are used as light sources, and a red fluorescent layer is used as a light transition medium. By adjusting the dosage of the chemical substances in the red fluorescent layer, the present invention can produce white lights of different color temperatures.

Besides, the three wavelength LED structure of the present invention uses the blue light LED chip and the green light LED chip as light sources, and a red fluorescent layer is used as a light transition layer. The increase and decrease in operation current can cause a shift of CIE coordinate of the two LED chips, and the red fluorescent layer can convert the light emitted from the two LED chips into neutral color light, thus achieving the objective of providing neutral color light.

In addition, by separately controlling the operation current of the blue light LED chip and the green light LED chip, the three wavelength LED structure of the present invention can produce a shift of CIE coordinate that changes with time, thus light color of the three wavelength LED is adjustable within a limited range.

The present invention will become more obvious from the following description when taken in connection with the accompanying drawings, which show, for purpose of illustrations only, the preferred embodiments in accordance with the present invention.

### BRIEF DESCRIPTION OF THE DRAWINGS

Fig. 1 shows a conventional bulb-shaped single color LED package structure;
Fig. 2 shows a conventional white light LED package structure formed by surface mounting technology;
Fig. 3 shows a three wavelength LED structure in accordance with an embodiment of the present invention is illustrated, wherein the three wavelength LED structure is used in a bulb type LED package structure; and
Fig. 4 shows another embodiment of the present invention, wherein the three wavelength LED structure is applied to a surface mounting type LED package structure.

### DETAILED DESCRIPTION OF THE PREFERRED EMBODIMENTS

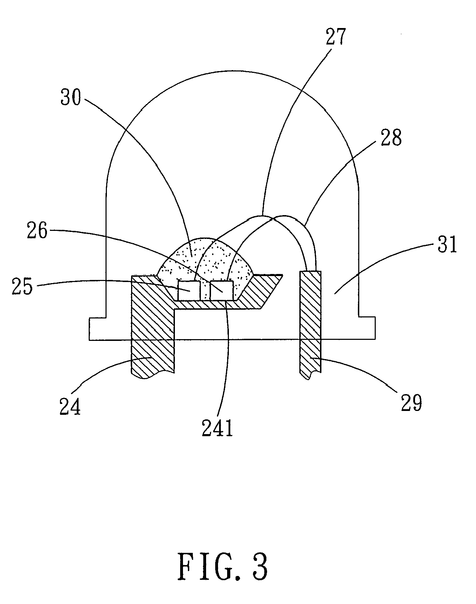

Referring to Fig. 3, a three wavelength LED structure in accordance with an embodiment of the present invention is illustrated, wherein the three wavelength LED structure is used in a bulb type LED package structure.

In this embodiment, a blue LED chip 25 having a wavelength of 420-475 nm and a green LED chip 26 having a wavelength of 495-550 nm are placed in a cup 241 formed at the end of a electrode supporting frame 24, and the two LED chips 25 and 26 are electrically connected to another electrode supporting frame 29 by welding wires 27 and 28.

A red fluorescent layer 30 is filled in the cup 241 and coated on the two LED chips 25 and 26. The red fluorescent layer 30 is made of composite colloid (such as: epoxy resin or silicone rubber) consisted of CaS:Eu²⁺,or SrS:Eu²⁺, or the Europium activated Nitridosilicates Ca₂Si₅N₇:Eu, Ca₂Si₅N₈ :Eu²⁺. The red fluorescent layer 30 can absorb one of the wavelengths of the two LED chips 25 and 26. CaS:Eu²⁺ can absorb the light of wavelength 420-570 nm and generate a red spectrum of wavelength 655 nm. SrS:Eu²⁺ can absorb the light of wavelength of 400-530 nm and generate a red spectrum of wavelength 625 nm. Europium activated Nitridosilicates can absorb the light of wavelength of 300-550 nm and generate a red spectrum of wavelength 600-700 nm. And finally these components (including the red fluorescent layer 30, the welding wires 27 and 28, and the LED chip 25) are encapsulated by a colloid 31, thus forming a bulb-type LED package structure.

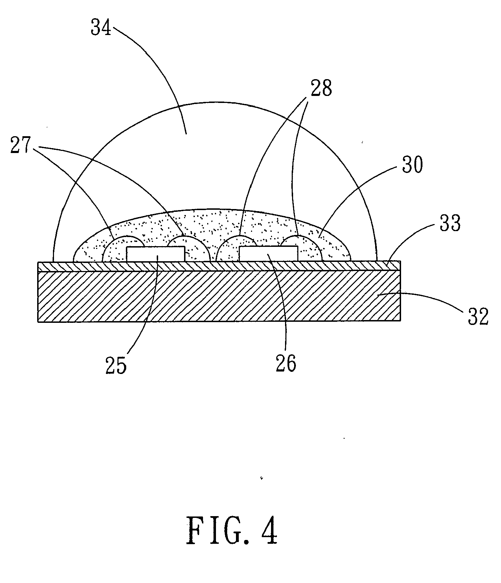

Referring to Fig. 4, which shows another embodiment of the present invention, wherein the three wavelength LED structure is applied to a surface mounting type LED package structure.

In this embodiment, a blue LED chip 25 having a wavelength of 420-475 nm and a green LED chip 26 having a wavelength of 495-550 nm are placed on a printed circuit layer 33, and the printed circuit layer 33 is located on a substrate 32. the LED chips 25 and 26 are electrically connected to the printed circuit layer 33, respectively, by two welding wires 27 and 28.

And then a red fluorescent layer 30 is filled in the cup 241 and coated on the two LED chips 25 and 26. The red fluorescent layer 30 is made of composite colloid (such as: epoxy resin or silicone rubber) consisted of CaS:Eu²⁺,orSrS:Eu²⁺,or the Europium activated Nitridosilicates Ca₂Si₅N₇:Eu, Ca₂Si₅N₈:Eu²⁺.The red fluorescent layer 30 can absorb one of the wavelengths of the two LED chips 25 and 26. CaS:Eu²⁺ can absorb the light of wavelength 420-570 nm and generate a red spectrum of peak wavelength 655 nm. SrS:Eu²⁺ can absorb the light of wavelength of 400-530 nm and generate a red spectrum of peak wavelength 625 nm. Europium activated Nitridosilicates can absorb the light of wavelength of 300-550 nm and generate a red spectrum of wavelength 600-700 nm. And finally these components (including the red fluorescent layer 30, the welding wires 27 and 28, and the LED chip 25) are encapsulated by a transparent colloid 34, thus forming a surface mounting type LED package structure.

The abovementioned three wavelength LED structure utilizes the chemical substances of the red fluorescent layer to absorb the blue and green lights generated from the blue and green LED chips. After absorbing the blue and green lights, the chemical substances can generate red spectrum of wavelength 600-700 nm, and the red spectrum will be mixed with the blue and green lights to form a white light (the three primary colors forming white light is red, green and blue).

Since the blue LED chip and the green LED chip are the same in electrical property, and they are generally the same in forward voltage and current, accordingly, it can use a drive circuit to control the blue LED chip and the green LED chip. If want to make a white light LED, it can adjust the number of the blue and the green LED chips in the three wavelength LED structure. For example, the proportion between the blue and green LED chips can be 1:3, 1:2, 1:1, 2:1, 3:1, etc, and with the adjustment in the amount of the chemical substances, the color temperature can be adjusted between 2500K-7000K. Besides, the white light generated by this structure is consisted of three primary colors (red, green and blue), and its color rendering index (Ra) will be as high as 90, thus improving the practical value of the present invention.

If the blue and green LED chips are controlled separately by different drive circuits, and the LED chips are adjusted separately to adjust the current, the increase and decrease in operation current will lead to a shift of CIE coordinate. If micro-adjusting the dosage of the chemical substances in the red fluorescent agent when producing the LED package structure, the light mixed by the blue light, the green light and the light generated after the activation of the chemical substances will be slightly reddish, greenish or bluish, thus creating different neutral colors, such as pink, baby blue, light green, light yellow or milky white. Besides, if the value of the drive current of the blue LED chip and that of the green LED chip are adjusted in time sequence, the CIE coordinate will shift with time. By taking the use of the phenomenon of CIE coordinate shift, it can produce a LED that is adjustable in light color. The advantage is that even if the three wavelength LED of the present invention has been processed into a finished product, the finished product of the LED still can generate different-colored lights by using different circuits to control the blue and the green LED chips or by using the design of time sequence control, thus improving the practical value of the present invention.

To summarize, the three wavelength LED structure of the present invention uses the blue light LED chip and the green light LED chip as light sources, and a red fluorescent layer is used as a light transition layer. By adjusting the number of the blue light LED chip and the green light LED chip and the dosage of the chemical substances in the red fluorescent layer, the present invention can produce a white light LED which is adjustable in color temperature, a neutral color LED whose color is changeable, or can produce a LED whose light color changes with time.

While we have shown and described various embodiments in accordance with the present invention, it should be clear to those skilled in the art that further embodiments may be made without departing from the scope of the present invention.

## Claims

1. A three wavelength light emitting diode (LED) comprising:
a substrate;
at least one printed circuit layer located on a surface of the substrate;
at least one blue light LED chip placed being on the substrate or on a surface of the printed circuit layer and electrically connected to the printed circuit layer;
at least one green light LED chip placed on the substrate or on a surface of the printed circuit layer, the green light LED chip being in electrical contact with the printed circuit layer and without contacting the blue light LED chip; and
a red fluorescent layer containing chemical substances capable of converting wavelength of electromagnetic waves, the blue light LED chip and the green light LED chip being encapsulated by the red fluorescent layer, and the red fluorescent layer adapted to convent a wavelength emitted by the blue light LED chip and the green light LED chip into another wavelength.

2. The three wavelength light emitting diode (LED) as claimed in claim 1, wherein the wavelength emitted by the blue light LED chip ranges from 420 to 475 nm.

3. The three wavelength light emitting diode (LED) as claimed in claim 1, wherein the wavelength emitted by the green light LED chip ranges from 495 to 550 nm.

4. The three wavelength light emitting diode (LED) as claimed in claim 1, wherein the chemical substances in the red fluorescent layer are selected from the group consisted of: consisted of CaS:Eu²⁺, or SrS:Eu²⁺, or Europium activated Nitridosilicates.

5. The three wavelength light emitting diode (LED) as claimed in claim 4, wherein the Europium activated Nitridosilicates are Ca₂Si₅N₇:Eu, Ca₂Si₅N ₈:Eu²⁺.

6. The three wavelength light emitting diode (LED) as claimed in claim 1 further comprising a transparent colloid located on the substrate for encapsulating the blue light LED chip, the green light LED chip, and the red fluorescent layer.

7. A three wavelength light emitting diode (LED) comprising:
two electrode supporting frames including a first electrode supporting frame and a second electrode supporting frame, a cup formed in an end of the first electrode supporting frame;
at least one blue light LED chip placed in the cup;
at least one green light LED chip being placed in the cup without contacting the blue light LED chip;
a plurality of welding wires for electrically connecting the blue light LED chip and the green light LED chip to the second electrode supporting frame; and
a red fluorescent layer containing chemical substances capable of converting wavelength of electromagnetic waves, being filled in the cap for encapsulating the blue light LED chip and the green light LED chip, and the red fluorescent layer adapted to convent a wavelength emitted by the blue light LED chip and the green light LED chip into another wavelength.

8. The three wavelength light emitting diode (LED) as claimed in claim 7, wherein the wavelength emitted by the blue light LED chip ranges from 420 to 475 nm.

9. The three wavelength light emitting diode (LED) as claimed in claim 7, wherein the wavelength emitted by the green light LED chip ranges from 495 to 550 nm.

10. The three wavelength light emitting diode (LED) as claimed in claim 7, wherein the chemical substances in the red fluorescent layer are selected from the group consisted of: consisted of CaS:Eu²⁺,or SrS:Eu²⁺,or Europium activated Nitridosilicates.

11. The three wavelength light emitting diode (LED) as claimed in claim 10, wherein the Europium activated Nitridosilicates are Ca₂Si₅N₇:Eu, Ca₂Si₅N ₈ : Eu²⁺.

12. The three wavelength light emitting diode (LED) as claimed in claim 7 further comprising a transparent colloid located on the substrate for encapsulating the two electrode supporting frames, and the red fluorescent layer.

13. A three wavelength light emitting diode (LED) comprising:
a substrate;
at least one conductive structure located on a surface of the substrate;
at least one blue light LED chip placed being on the substrate or the conductive structure and electrically connected to the printed circuit layer;
at least one green light LED chip placed on the substrate or the conductive structure, the green light LED chip being in electrical contact with the conductive structure and without contacting the blue light LED chip; and
a red fluorescent layer containing chemical substances capable of converting wavelength of electromagnetic waves, and the blue light LED chip and the green light LED chip being encapsulated by the red fluorescent layer.

14. The three wavelength light emitting diode (LED) as claimed in claim 13, wherein the wavelength emitted by the blue light LED chip ranges from 420 to 475 nm.

15. The three wavelength light emitting diode (LED) as claimed in claim 13, wherein the wavelength emitted by the green light LED chip ranges from 495 to 550 nm.

16. The three wavelength light emitting diode (LED) as claimed in claim 13, wherein the chemical substances in the red fluorescent layer are selected from the group consisted of: consisted of CaS:Eu²⁺,or SrS:Eu²⁺,or Europium activated Nitridosilicates.

17. The three wavelength light emitting diode (LED) as claimed in claim 16, wherein the Europium activated Nitridosilicates are Ca₂Si₅N₇:Eu, Ca₂Si₅N ₈:Eu²⁺.
